# EUROPÄISCHE PATENTSCHRIFT

(11) **EP 2 753 728 B1**
(45) Veröffentlichungstag und Bekanntmachung des Hinweises auf die Patenterteilung: **12.12.2018**
(21) Anmeldenummer: 12756005.0
(22) Anmeldetag: 05.09.2012
(51) Int. Cl.: C23C 28/04, C23C 14/08, C23C 30/00, C23C 14/06, C23C 14/32, C23C 14/35

(54) **WERKZEUG MIT CHROMHALTIGER FUNKTIONSSCHICHT**
TOOL WITH CHROMIUM-CONTAINING FUNCTIONAL LAYER
OUTIL POURVU D'UNE COUCHE FONCTIONNELLE CONTENANT DU CHROME

(30) Priorität: 07.09.2011 DE 102011053372
(43) Veröffentlichungstag der Anmeldung: 16.07.2014
(73) Patentinhaber: Walter AG, 72072 Tübingen (DE)
(72) Erfinder: SCHIER, Veit, 70771 Leinfelden-Echterdingen (DE); ENGELHART, Wolfgang, 72555 Metzingen (DE)
(74) Vertreter: WSL Patentanwälte Partnerschaft mbB
(86) Internationale Anmeldenummer: PCT/EP2012/067328
(87) Internationale Veröffentlichungsnummer: WO 2013/034598

(56) Entgegenhaltungen:
- WO-A1-2009/110831
- WO-A2-2008/138789
- WO-A2-2008/138789
- DE-A1-102007 030 734
- DE-A1-102007 030 734
- DE-A1-102010 028 558
- JP-A- 2006 198 731
- US-A1- 2004 121 147
- US-A1- 2009 252 973

## Beschreibung

### Gegenstand der Erfindung

Die vorliegende Erfindung betrifft ein Schneidwerkzeug mit einem Substrat aus Hartmetall, Cermet, Stahl oder Schnellarbeitsstahl (HSS) und einer darauf im PVD-Verfahren abgeschiedenen mehrlagigen Beschichtung nach Anspruch 1.

### Hintergrund der Erfindung

Schneidwerkzeuge, die beispielsweise zur spanabhebenden Metallbearbeitung eingesetzt werden, bestehen in der Regel aus einem Grundkörper (Substrat) aus Hartmetall, Cermet, Stahl oder Schnellarbeitsstahl mit einer verschleißbeständigen ein- oder mehrlagigen Beschichtung aus metallischen Hartstoffschichten, Oxidschichten und dergleichen. Zum Aufbringen solcher Beschichtungen werden CVD-Verfahren (chemische Gasphasenabscheidung) und/oder PVD-Verfahren (physikalische Gasphasenabscheidung) angewendet.

Aus der EP 1 253 215 ist es bekannt, auf einem Hartmetallsubstrat im PVD-Verfahren eine mehrlagige Beschichtung mit einer Basislage aus TiAIN und einer Funktionslage aus Aluminiumoxid oder Aluminium-Chrom-Oxid abzuscheiden. Dabei wird Aluminiumoxid im Single-Magnetron-Verfahren abgeschieden, wobei überwiegend Gamma-Aluminiumoxid entsteht. Aluminium-Chrom-Oxid wird im Lichtbogen-PVD-Verfahren abgeschieden, wobei stabiles Alpha-Aluminium-Chrom-Oxid entsteht, jedoch besitzt dieses eine schlechte Anbindung an die darunterliegende TiAIN-Basislage, und es bilden sich verfahrensbedingt sehr viele Makropartikel, sogenannten Droplets, welche die Qualität der Funktionslage erheblich verschlechtern.

Die DE 10 2010 028 558 beschreibt ein PVD-Hybridverfahren zum Abscheiden von Aluminium-Chrom-Oxid-Mischkristallschichten, bei dem man gleichzeitig die PVD-Verfahren Kathodenzerstäubung und Lichtbogenverdampfen anwendet. Man erhält Aluminium-Chrom-Oxid-Mischkristallschichten überwiegend in der stabilen Alphaphase, die im Wesentlichen frei sind von Makropartikeln (Droplets).

Die WO 2008/138789 A2 offenbart ein Schneidwerkzeug mit einem Substrat aus Hartmetall, kubischem Bornitrid (CBN), Cermet oder einem keramischen Metall mit einer im PVD-Verfahren abgeschiedenen mehrlagigen Beschichtung, welche eine auf dem Substrat abgeschiedene Haftverbundlage, beispielsweise aus TiN oder TiCN, und darüber wenigstens eine oxidische Lage aufweist, wobei die oxidische Lage stets die äußerste Lage der mehrlagigen PVD-Beschichtung darstellt. Die oxidische Lage kann verschiedenste Kristallstrukturen aufweisen, einschließlich kubische, hexagonale oder Spinell-Struktur. Als ein Beispiel für eine oxidische Lage ist Aluminium-Chromoxid (AlCr)₂O₃ mit Korund-Struktur angegeben.

Die DE 10 2007 030 734 A1 offenbart ein Schneidwerkzeug mit einem Substrat aus Hartmetall, Cermet, Stahl oder Schnellarbeitsstahl mit einer im PVD-Verfahren abgeschiedenen mehrlagigen Beschichtung, welche als verschleißbeständige Funktionslage eine zwei- oder mehrphasige Lage umfasst, die wenigstens zwei verschiedene Phasen von Metalloxid enthält und elektrisch leitfähig ist. Indem die oxidische Funktionslage elektrisch leitfähig hergestellt wird, lassen sich im PVD-Verfahren auch dickere oxidische Schichten aufbringen. Es wird angenommen, dass die elektrische Leitfähigkeit der oxidischen Funktionslage durch die Bildung einer metastabilen Phase von Chromoxid erzielt wird. Als Beispiel für eine oxidischen Funktionslage ist eine (Al,Cr)₂O₃-Lage angegeben, welche vier Phasen umfasst, nämlich eine stabile γ-Al₂O₃-Phase, zwei stabile Cr-Oxid-Phasen (CrO₃, Cr₂O₃) und eine metastabile Cr-Oxid-Phase (CrOₓ).

Die WO 2009/110831 A1 offenbart ein Schneidwerkzeug mit einem Substrat aus Hartmetall, Cermet, Keramik, kubischem Bornitrid oder Schnellarbeitsstahl und einer ein- oder mehrlagigen Beschichtung, welche eine im PVD-Verfahren abgeschiedene (Al,Cr)₂O₃-Lage mit einer bestimmten Fasertextur und mit Korund-Struktur umfasst. Zwischen dem Substrat und der (Al,Cr)₂O₃-Lage können eine oder mehrere Carbid- oder Nitrid-Zwischenlagen vorgesehen sein.

Die US 2004/0121147 A1 offenbart Hartstoffbeschichtungen für verschleißbeständige Gegenstände, wie beispielsweise Schneidwerkzeuge, aber auch für andere Substrate. Die Beschichtung weist eine oxidische Lage mit Korund-Struktur auf, welche neben Cr₂O₃ und (Fe,Cr)₂O₃ auch aus (Cr,Al)₂O₃ bestehen kann. Zwischen dem Substrat und der oxidischen Lage kann eine TiAIN-Lage vorgesehen sein. Über der oxidischen Lage ist eine weitere Lage aus Aluminiumoxid mit Korund-Struktur angeordnet.

Die US 2009/0252973 A1 offenbart einen Körper mit einem Substrat und einer durch Magnetron-Sputtern aufgebrachten Al-Cr-Si-Oxidschicht. Durch einen hohen Sauerstoffanteil in dieser Schicht von mehr als 30% soll die Oxidationsbeständigkeit der Schicht verbessert werden. Unter der Oxidischicht ist eine Haftverbundlage vorgesehen, welche Al, Cr, Si und N enthält und beispielsweise aus (AI,Cr,Si)N besteht.

Die JP 2006-198731 A offenbart ein Schneidwerkzeug mit einem Substrat aus Hartmetall oder Cermet und einer mehrlagigen Beschichtung, welche eine erste Lage aus TiAIN, eine Zwischenschicht aus Cr₂O₃ und eine äußere (Al,Cr)₂O₃-Lage mit Korundstruktur aufweist.

Nach den im Stand der Technik bekannten Verfahren ist es möglich, Aluminiumoxid, Aluminium-Chrom-Mischoxid oder Mischoxide mit weiteren Legierungselementen in der stabilen Alphamodifikation herzustellen. Diese Schichten zeichnen sich jedoch durch eine schlechte Anbindung an den Untergrund, beispielsweise eine nitridische Basislage, wie eine TiAIN-Lage, aus. Das Vorsehen einer solchen Basislage ist jedoch erwünscht, weil direkt auf der Substratoberfläche abgeschiedene Oxidschichten häufig zu spröde für die Funktion als Verschleißschutzschicht sind.

### Aufgabe der Erfindung

Die Aufgabe der vorliegenden Erfindung bestand daher darin, bei einem Schneidwerkzeug aus einem Substrat mit einer mehrlagigen Beschichtung die Anbindung einer chromhaltigen Funktionslage auf einer Basislage aus Nitrid oder Carbonitrid enthaltenden Hartstoffen zu verbessern.

### Beschreibung der Erfindung

Gelöst wird diese Aufgabe erfindungsgemäß durch ein Schneidwerkzeug mit einem Substrat aus Hartmetall, Cermet, Stahl oder Schnellarbeitsstahl (HSS) und einer darauf im PVD-Verfahren abgeschiedenen mehrlagigen Beschichtung, welche ausgehend von dem Substrat folgende Schichtabfolge umfasst:
a) eine Basislage aus einer oder mehreren übereinander angeordneten gleichen oder verschiedenen Schichten aus einem Nitrid oder Carbonitrid, welche wenigstens Aluminium (Al) und optional ein oder mehrere weitere Metalle, ausgewählt unter Ti, Cr, Si, Y, Ru und Mo, enthält,
b) eine unmittelbar über der Basislage angeordnete Zwischenlage aus kubischem Aluminiumoxid,
c) eine über der Zwischenlage angeordnete chromhaltige Funktionslage mit rhomboedrischer Struktur, ausgewählt unter Chromoxid (Cr₂O₃), Chromoxinitrid, Aluminium-Chrom-Oxid (AlCr)₂O₃, Aluminium-Chrom-Oxinitrid oder einem Mischoxid oder Mischoxinitrid aus Aluminium, Chrom und weiteren Metallen (AlCrMe₁,.....Meₙ)₂-Oxid oder (AlCrMe₁,.....Meₙ)₂-Oxinitrid, wobei Me₁....Meₙ ein oder mehrere weitere Metalle bedeutet, ausgewählt unter Hf, Y, Zr und Ru. n ist eine ganze Zahl entsprechend der Anzahl der in dem Mischoxid oder Mischoxinitrid neben Aluminium und Chrom vorhandenen weiteren Metalle.

In einer bevorzugten Ausführungsform der vorliegenden Erfindung besteht in der Beschichtung des Schneidwerkzeugs die Basislage aus Titan-Aluminium-Nitrid (TiAIN) oder Titan-Aluminium-Silizium-Nitrid (TiAlSiN), besonders bevorzugt aus Titan-Aluminium-Nitrid (TiAIN). Titan-Aluminium-Nitrid (TiAIN) eignet sich sehr gut als Basislage, da sie sehr zäh und hart ist und insbesondere bei hohen Temperaturen, die bei der Metallbearbeitung auftreten, hervorragende Verschleißeigenschaften besitzt.

Es konnte gezeigt werden, dass das Vorsehen der erfindungsgemäßen Zwischenlage über der erfindungsgemäßen Basislage, welche vorzugsweise aus TiAIN besteht, die Anbindung und Haftung der darüber angeordneten chromhaltigen Funktionslage erheblich verbessert. In Zerspanversuchen mit Schneidwerkzeugen aus einem Hartmetallsubstrat, einer erfindungsgemäßen Basislage, einer erfindungsgemäßen Zwischenlage aus kubischem Aluminiumoxid, vorzugsweise aus kubischem Gamma-Aluminiumoxid, und einer erfindungsgemäßen Funktionslage mit rhomboedrischer Struktur, beispielsweise einer Lage aus Aluminium-Chrom-Oxid, im Vergleich mit einem entsprechenden Schneidwerkzeug ohne die Zwischenlage wurde mit der erfindungsgemäßen Beschichtung mit Zwischenlage ein erheblich geringerer Verschleiß des Werkzeugs erzielt.

Die chromhaltige Funktionslage weist erfindungsgemäß eine rhomboedrische Kristallstruktur auf. Die Funktionslage kann reines Chromoxid (Cr₂O₃), Chromoxinitrid, Aluminium-Chrom-Oxid (AlCr)₂O₃, Aluminium-Chrom-Oxinitrid oder ein Aluminium-Chrom-Mischoxid oder Mischoxinitrid mit weiteren Metallen, ausgewählt unter Hf, Y, Zr und Ru, sein. Besonders bevorzugt besteht die chromhaltige Funktionslage vollständig oder wenigstens zu 90 Vol.-% aus Aluminium-Chrom-Oxid mit rhomboedrischer Kristallstruktur, d.h. aus Aluminium-Chrom-Oxid in der Alpha-Modifikation. Wenn hierin von Aluminium-Chrom-Oxid (AlCr)₂O₃ die Rede ist, bedeutet dies nicht zwangsläufig, dass die Elemente Aluminium und Chrom in gleichen stöchiometrischen Anteilen vorliegen. Der Anteil an Chrom kann höher oder niedriger als der Anteil von Aluminium in der Aluminium-Chrom-Oxid-Lage sein.

In einer bevorzugten Ausführungsform der vorliegenden Erfindung beträgt der Chromanteil unter den metallischen Elementen der Funktionslage mindestens 70 At.-% Cr. In einer weiteren Ausführungsform beträgt der Chromanteil wenigstens 85 At.-% Cr oder wenigstens 95 At.-% Cr. Ein hoher Chromanteil in der Funktionslage hat den Vorteil, dass er das Aufwachsen der Funktionsschicht in der erwünschten rhomboedrischen Struktur fördert.

Die erfindungsgemäße Zwischenlage, die unmittelbar über der Basislage angeordnet ist, besteht aus Aluminiumoxid und weist eine kubische Struktur auf. In einer bevorzugten Ausführungsform der vorliegenden Erfindung besteht die Zwischenlage aus kubischem Gamma-Aluminiumoxid (γ-Al₂O₃).

Die Verbesserung der Haftung bzw. Anbindung der Funktionslage an der Basislage durch das Vorsehen der erfindungsgemäßen Zwischenlage mit kubischer Struktur war überraschend. Es gibt bislang auch keine nachgewiesene Erklärung dafür, weshalb gerade eine solche kubische Zwischenlage die Haftung bzw. Anbindung der Funktionslage auf der Basislage derart verbessert. Die Erfinder der vorliegenden Anmeldung haben an den erfindungsgemäßen Lagen (Basislage, Zwischenlage und Funktionslage) XPS-Messungen (Röntgenphotoelektronenspektroskopie) durchgeführt. Bei XPS-Messungen an der Funktionslage einer Beschichtung mit erfindungsgemäßer Zwischenlage wurde an der Oberfläche der Funktionslage, welche der Zwischenlage zugewandt ist, im Vergleich zu einer Beschichtung ohne die erfindungsgemäße Zwischenlage ein erhöhter metallischer Anteil von Chrom aufgefunden. Ohne sich an diese Theorie zu binden, vermuten die Erfinder, dass die Ausbildung einer Übergangszone mit einem höheren Anteil an metallischen Bindungen zwischen der kubischen Zwischenlage und der rhomboedrischen Funktionslage zu der verbesserten Anbindung der Funktionslage beitragen oder diese bewirken könnte.

Die Zwischenlage der erfindungsgemäßen Beschichtung kann im Wesentlichen durch jedes dafür geeignete PVD-Verfahren abgeschieden werden. Bevorzugt sind jedoch Magnetronsputtern, reaktives Magnetronsputtern, duales Magnetronsputtern, High Power Impulse Magnetronsputtern (HIPIMS) oder die gleichzeitige Anwendung von Kathodenzerstäubung (Sputter-Abscheidung) und Lichtbogenverdampfen (Arc-PVD), auch PVD-Hybridverfahren genannt.

Auch die Funktionslage kann durch jedes geeignete PVD-Verfahren abgeschieden werden. Bevorzugt sind Lichtbogenverdampfen (Arc-PVD), Magnetronsputtern, reaktives Magnetronsputtern, duales Magnetronsputtern, High Power Impulse Magnetronsputtern (HIPIMS) oder gleichzeitige Anwendung von Kathodenzerstäubung (Sputter-Abscheidung) und Lichtbogenverdampfen (Arc-PVD), bzw. PVD-Hybridverfahren.

In einer bevorzugten Ausführungsform des erfindungsgemäßen Schneidwerkzeugs hat die Basislage eine Schichtdicke von 50 nm bis 8 µm, vorzugsweise von 500 nm bis 5 µm, besonders bevorzugt von 2 µm bis 4 µm.
In einer weiteren Ausführungsform des erfindungsgemäßen Schneidwerkzeugs hat die Zwischenlage eine Schichtdicke von 1 nm bis 2 µm, vorzugsweise von 5 nm bis 750 nm, besonders bevorzugt von 10 nm bis 50 nm.

In einer weiteren bevorzugten Ausführungsform des erfindungsgemäßen Schneidwerkzeugs hat die Funktionslage eine Schichtdicke von 100 nm bis 10 µm, vorzugsweise von 500 nm bis 5 µm, besonders bevorzugt von 750 nm bis 2 µm.

In einer weiteren bevorzugten Ausführungsform des erfindungsgemäßen Schneidwerkzeugs weist die Funktionslage Druckspannungen an der Oberfläche von weniger als 2 GPa, vorzugsweise weniger als 1 GPa auf. Es wurde überraschenderweise festgestellt, dass gerade bei höheren Schichtdicken der Funktionslage eine geringere Gerfahr der Delamination besteht, wenn die Druckspannungen an der Oberfläche unter 2 GPa liegen. Eine weitere Verbesserung wurde bei Druckspannungen an der Oberfläche von weniger als 1 GPa beobachtet.

In einer weiteren bevorzugten Ausführungsform des erfindungsgemäßen Schneidwerkzeugs enthält die Zwischenlage 0,1 bis 5 At.-%, vorzugsweise 0,5 bis 4 At.-%, besonders bevorzugt 1,0 bis 3 At.-% Argon enthält. Der Argonanteil stammt aus dem Reaktivgas der PVD-Abscheidung und wirkt sich in einigen Fällen vorteilhaft auf die Anbindung der Funktionsschicht an die darunter liegende Zwischenschicht aus.

Die vorliegende Erfindung wird nun anhand von Ausführungsbeispielen und den dazugehörigen Figuren weiter erläutert.

### 1. Herstellung von Schneidwerkzeugen mit und ohne Zwischenlage

Auf einem Hartmetallsubstrat mit einer mittleren Korngröße von etwa 1 µm und einem Co-Gehalt von etwa 10 Gew.-% wurde **zunächst** eine TiAIN-Basislage mit einer Dicke von 4,6 µm durch Lichtbogenverdapfen (Arc-PVD) unter Anwendung der folgenden Parameter aufgebracht:

### Basislage

| | |
|---|---|
| Target (Arc-PVD): | TiAl (33 At.-% / 67 At.-%) -Metall |
| Targetdurchmesser [mm]: | 63 |
| U_{bias} [-V]: | 40 (DC) |
| N₂-Partialdruck [Pa]: | 3,2 |
| I_{Arc-PVD} [A]: | 65 |

Zur Herstellung von erfindungsgemäßen Schneidwerkzeugen wurde darüber eine Zwischenlage aus Gamma-Aluminiumoxid mit einer Dicke von 14 nm durch duales Magnetronsputtern (DMS) mit folgenden Parametern abgeschieden:

### Zwischenlage

| | |
|---|---|
| Targets (DMS): | 2 x Al-Metall |
| Targetgröße [mm x mm]: | 160 x 820 |
| Leistung (DMS) [kW]: | 20 |
| U_{bias} [V]: | 60 (unipolar gepulst, 70 Hz) |
| Dauer [min]: | 6 |
| Ar-Partialdruck [Pa]: | 0,5 |

Im Anschluss daran wurde auf Werkzeugen mit der erfindungsgemäßen Zwischenlage (Erfindung) und ohne eine Zwischenlage (Vergleich) eine 1,5 µm dicke rhomboedrische Alpha-Aluminium-Chrom-Oxidschicht in einem PVD-Hybridverfahren unter gleichzeitiger Anwendung von dualem Magnetronsputtern (DMS) und Lichtbogenverdampfen (Arc-PVD) mit folgenden Parametern abgeschieden:

### Funktionslage

| | |
|---|---|
| Targets (DMS): | 2 x AI-Metall |
| Targetgröße [mm x mm]: | 160 x 820 |
| Leistung DMS [kW]: | 20 |
| Targets (Arc-PVD): | 8 x Cr-Metall |
| I_{Arc-PVD} [A]: | 65 |
| U_{bias} [-V]: | 60 (unipolar gepulst, 70 Hz) |
| Dauer [min]: | 6 |

### 2. Zerspanversuche

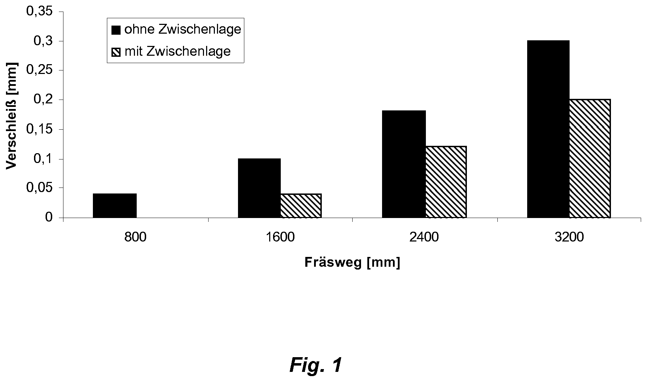

Mit den zuvor gemäß 1. hergestellten Schneidwerkzeugen mit und ohne Zwischenlage wurde ein Werkstück aus 42 CrMo4 mit einer Schnittgeschwindigkeit v_{c} = 235 m/min und einem Vorschub f_{z} = 0,2 mm gefräst. Die Ergebnisse sind in dem Diagramm gemäß Figur 1 wiedergegeben, worin der Verschleiß [mm] in Abhängigkeit von unterschiedlichen Fräswegen [mm] dargestellt ist. Die Ergebnisse zeigen, dass der Verschleiß der mit der Zwischenlage hergestellten Schneidwerkzeuge gegenüber Schneidwerkzeugen ohne die Zwischenlage erheblich geringer ist. Bei einem Fräsweg von 800 mm wurde bei erfindungsgemäßen Schneidwerkzeugen mit Zwischenlage überhaupt kein Verschleiß festgestellt. Bei einem Fräsweg von 1600 mm war der Verschleiß bei dem Schneidwerkzeug ohne Zwischenlage mehr als doppelt so hoch wie bei dem erfindungsgemäßen Schneidwerkzeug mit erfindungsgemäßer Zwischenlage.

Durch die deutlich verbesserte Haftung bzw. Anbindung der Funktionslage erhält man Schneidwerkzeuge mit erheblich geringerem Verschleiß und kann damit erheblich höhere Standzeiten als bisher erreichen. Dies bedeutet eine Einsparung von Schneidwerkzeugen, seltenere Wechsel der Schneidwerkzeuge und damit weniger Ausfall und Stillstandszeiten der Maschinen, eine höhere Produktivität und geringere Kosten.

### 3. Lichtmikroskopische Untersuchungen der Schneidwerkzeuge mit und ohne Zwischenlage

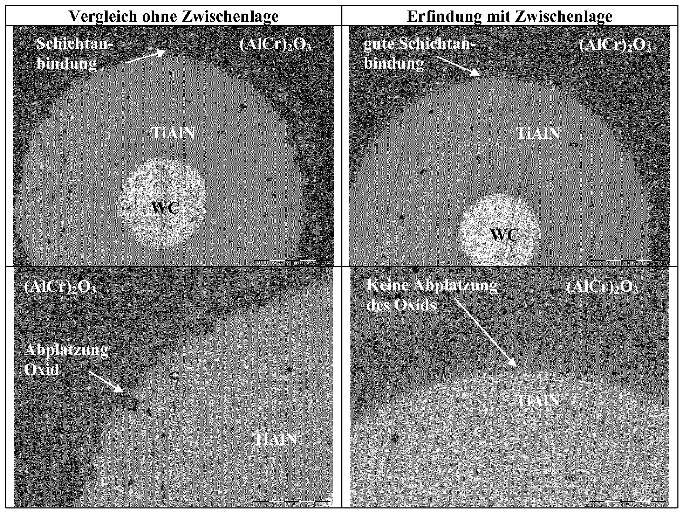

In die Beschichtung der gemäß 1. hergestellten Schneidwerkzeuge mit und ohne die erfindungsgemäße Zwischenlage wurde ein Kalottenschliff eingebracht. Dabei wird mit Hilfe einer Kugel eine Mulde geschliffen, die in der Mitte bis zum Hartmetallsubstrat reicht. Im Lichtmikroskop ist dann das Hartmetallsubstrat, die TiAIN-Basislage und die Aluminium-Chrom-Oxid-Lage zu erkennen. Die wenige Nanometer dicke Zwischenlage wird im Lichtmikroskop nicht aufgelöst und ist daher nicht als eine diskrete Lage zu erkennen. Die lichtmikroskopischen Aufnahmen der geschliffenen Schneidwerkzeuge sind in Figur 2 wiedergegeben.

Bei dem Schneidwerkzeug ohne die erfindungsgemäße Zwischenlage erkennt man am Übergang zwischen der TiAIN-Basislage und der Aluminium-Chrom-Oxid-Funktionslage deutlich einen dunklen, ausgefransten Zwischenring von sogenannten Ausplatzungen, die ein Hinweis auf eine schlechte Schichtanbindung zwischen zwei Lagen sind. Eine gute Haftung zwischen zwei Lagen liegt vor, wenn der Übergang zwischen den beiden Lagen einen scharfen Rand zeigt. Dies ist deutlich bei dem erfindungsgemäßen Schneidwerkzeug mit der erfindungsgemäßen kubischen Zwischenlage zu erkennen.

### 4. XPS (Röntgenphotoelektronenspektroskopie) der Funktionsschicht von Schneidwerkzeugen mit und ohne erfindungsgemäße Zwischenlage

Durch XPS-Spektren der Funktionslage auf der dem Substrat zugewandten Seite der gemäß 1. hergestellten Schneidwerkzeuge ohne Zwischenlage bzw. mit Zwischenlage konnte gezeigt werden, dass die Funktionslage des Schneidwerkzeugs mit der erfindungsgemäßen Zwischenlage an der Grenzfläche einen höheren metallischen Anteil an Chrom aufweist als das Schneidwerkzeug ohne die erfindungsgemäße Zwischenlage. Wie bereits ausgeführt, vermuten die Erfinder, dass die verbesserte Anbindung der Funktionslage durch Ausbilden einer Übergangszone mit einem höheren Anteil an metallischen Bindungen zwischen der kubischen Zwischenlage und der rhomboedrischen Funktionslage erfolgt.

## Patentansprüche

1. Schneidwerkzeug mit einem Substrat aus Hartmetall, Cermet, Stahl oder Schnellarbeitsstahl (HSS) und einer darauf im PVD-Verfahren abgeschiedenen mehrlagigen Beschichtung, welche ausgehend von dem Substrat folgende Schichtabfolge umfasst:
a) eine Basislage aus einer oder mehreren übereinander angeordneten gleichen oder verschiedenen Schichten aus einem Nitrid oder Carbonitrid, welche wenigstens Aluminium (Al) und optional ein oder mehrere weitere Metalle, ausgewählt unter Ti, Cr, Si, Y, Ru und Mo, enthält,
b) eine unmittelbar über der Basislage angeordnete Zwischenlage aus kubischem Aluminiumoxid,
c) eine über der Zwischenlage angeordnete chromhaltige Funktionslage mit rhomboedrischer Struktur, ausgewählt unter Chromoxid (Cr₂O₃), Chromoxinitrid, Aluminium-Chrom-Oxid (AlCr)₂O₃, Aluminium-Chrom-Oxinitrid oder einem Mischoxid oder Mischoxinitrid aus Aluminium, Chrom und weiteren Metallen (AlCrMe₁,.....Meₙ)₂-Oxid oder (AlCrMe₁,.....Meₙ)₂-Oxinitrid, wobei Me₁....Meₙ ein oder mehrere weitere Metalle bedeutet, ausgewählt unter Hf, Y, Zr und Ru.

2. Schneidwerkzeug nach Anspruch 1, **dadurch gekennzeichnet, dass** die Zwischenlage aus kubischem Gamma-Aluminiumoxid (γ-Al₂O₃) besteht.

3. Schneidwerkzeug nach einem der Ansprüche 1 oder 2, **dadurch gekennzeichnet, dass** die chromhaltige Funktionslage vollständig oder wenigstens zu 90 Vol.-% aus rhomboedrischem Aluminium-Chrom-Oxid (AlCr)₂O₃ besteht.

4. Schneidwerkzeug nach einem der Ansprüche 1 bis 3, **dadurch gekennzeichnet, dass** der Chromanteil unter den metallischen Elementen der Funktionslage wenigstens 70 At.-% Cr oder wenigstens 85 At.-% Cr oder wenigstens 95 At.-% Cr beträgt.

5. Schneidwerkzeug nach einem der Ansprüche 1 bis 4, **dadurch gekennzeichnet, dass** die Zwischenlage durch Magnetronsputtern, reaktives Magnetronsputtern, duales Magnetronsputtern, High Power Impulse Magnetronsputtern (HIPIMS) oder unter gleichzeitiger Anwendung von Kathodenzerstäubung (Sputter-Abscheidung) und Lichtbogenverdampfen (Arc-PVD) abgeschieden wurde.

6. Schneidwerkzeug nach einem der Ansprüche 1 bis 5, **dadurch gekennzeichnet, dass** die Funktionslage durch Lichtbogenverdampfen (Arc-PVD), Magnetronsputtern, reaktives Magnetronsputtern, duales Magnetronsputtern, High Power Impulse Magnetronsputtern (HIPIMS) oder unter gleichzeitiger Anwendung von Kathodenzerstäubung (Sputter-Abscheidung) und Lichtbogenverdampfen (Arc-PVD) abgeschieden wurde.

7. Schneidwerkzeug nach einem der vorangegangenen Ansprüche, **dadurch gekennzeichnet, dass** die Basislage eine Schichtdicke von 50 nm bis 8 µm, vorzugsweise von 500 nm bis 5 µm, besonders bevorzugt von 2 µm bis 4 µm aufweist.

8. Schneidwerkzeug nach einem der vorangegangenen Ansprüche, **dadurch gekennzeichnet, dass** die Zwischenlage eine Schichtdicke von 1 nm bis 2 µm, vorzugsweise von 5 nm bis 750 nm, besonders bevorzugt von 10 nm bis 50 nm aufweist.

9. Schneidwerkzeug nach einem der vorangegangenen Ansprüche, **dadurch gekennzeichnet, dass** die Funktionslage eine Schichtdicke von 100 nm bis 10 µm, vorzugsweise von 500 nm bis 5 µm, besonders bevorzugt von 750 nm bis 2 µm aufweist.

10. Schneidwerkzeug nach einem der vorangegangenen Ansprüche, **dadurch gekennzeichnet, dass** die Funktionslage Druckspannungen an der Oberfläche von weniger als 2 GPa, vorzugsweise weniger als 1 GPa aufweist.

11. Schneidwerkzeug nach einem der vorangegangenen Ansprüche, **dadurch gekennzeichnet, dass** die Basislage aus Titan-Aluminium-Nitrid (TiAIN) oder Titan-Aluminium-Silizium-Nitrid (TiAlSiN) besteht.

12. Schneidwerkzeug nach einem der vorangegangenen Ansprüche, **dadurch gekennzeichnet, dass** die Zwischenlage 0,1 bis 5 At.-%, vorzugsweise 0,5 bis 4 At.-%, besonders bevorzugt 1,0 bis 3 At.-% Argon enthält.

## Claims

1. Cutting tool including a substrate of cemented carbide, cermet, steel or high-speed steel (HSS) and a multi-layer coating deposited thereon by a PVD process, wherein starting from the substrate the multi-layer coating comprises the following sequence of layers:
a) a base layer consisting of one or more identical or different layers arranged one on top of another of a nitride or carbonitride and which contains at least aluminium (Al) and optionally one or more further metals selected from Ti, Cr, Si, Y, Ru and Mo,
b) an intermediate layer arranged directly on top of the base layer consisting of cubic aluminium oxide,
c) a chromium-containing functional layer having a rhombohedral structure and being arranged above the intermediate layer and being selected from chromium oxide (Cr₂O₃), chromium oxynitride, aluminium-chromium oxide (AlCr)₂O₃, aluminium-chromium oxynitride or a mixed oxide or mixed oxynitride of aluminium, chromium and further metals (AlCrMe₁,...Meₙ)₂ oxide or (AlCrMe₁,....Meₙ)₂ oxynitride, in which Me₁,...Meₙ means one or more further metals selected from Hf, Y, Zr and Ru.

2. Cutting tool according to claim 1, **characterised in that** the intermediate layer consists of cubic gamma aluminium oxide (γ-Al₂O₃).

3. Cutting tool according to one of claims 1 or 2, **characterised in that** the chromium-containing functional layer consists completely or at least to the extent of 90 vol. % of rhombohedral aluminium-chromium oxide (AlCr)₂O₃.

4. Cutting tool according to one of claims 1 to 3, **characterised in that** the proportion of chromium among the metallic elements of the functional layer is at least 70 at.% Cr or at least 85 at.% Cr or at least 95 at.% Cr.

5. Cutting tool according to one of claims 1 to 4, **characterised in that** the intermediate layer is deposited by magnetron sputtering, reactive magnetron sputtering, dual magnetron sputtering, high power impulse magnetron sputtering (HIPIMS) or with simultaneous application of cathode atomisation and arc evaporation.

6. Cutting tool according to one of claims 1 to 5, **characterised in that** the functional layer is deposited by arc evaporation, magnetron sputtering, reactive magnetron sputtering, dual magnetron sputtering, high power impulse magnetron sputtering (HIPIMS) or with simultaneous application of cathode atomisation and arc evaporation.

7. Cutting tool according to one of the preceding claims, **characterised in that** the base layer exhibits a coating thickness of from 50 nm to 8 µm, preferably from 500 nm to 5 µm, particularly preferably from 2 µm to 4 µm.

8. Cutting tool according to one of the preceding claims, **characterised in that** the intermediate layer exhibits a coating thickness of from 1 nm to 2 µm, preferably from 5 nm to 750 nm, particularly preferably from 10 nm to 50 nm.

9. Cutting tool according to one of the preceding claims, **characterised in that** the functional layer exhibits a coating thickness of from 100 nm to 10 µm, preferably from 500 nm to 5 µm, particularly preferably from 750 nm to 2 µm.

10. Cutting tool according to one of the preceding claims, **characterised in that** the functional layer exhibits compressive residual stress at the surface of less than 2 GPa, preferably of less than 1 GPa.

11. Cutting tool according to one of the preceding claims, **characterised in that** the base layer consists of titanium-aluminium nitride (TiAIN) or titanium-aluminium-silicon nitride (TiAlSiN).

12. Cutting tool according to one of the preceding claims, **characterised in that** the intermediate layer contains 0.1 to 5 at.%, preferably 0.5 to 4 at.%, particularly preferably 1.0 to 3 at.% argon.

## Revendications

1. Outil de coupe pourvu d'un substrat en métal dur, cermet, acier ou acier à coupe rapide (HSS) et d'un revêtement multicouche y déposé par un procédé PVD, lequel revêtement comprend à partir du substrat :
a) une couche de base constituée d'une ou de plusieurs couches identiques ou différentes d'une nitrure ou carbonitrure disposées les unes sur les autres, qui comprend au moins de l'aluminium (Al) et en option un ou plusieurs autres métaux choisis parmi Ti, Cr, Si, Y, Ru et Mo,
b) une couche intermédiaire en oxyde d'aluminium cubique disposée directement au-dessus de la couche de base,
c) une couche fonctionnelle contenant du chrome, à structure rhomboédrique, disposée au-dessus de la couche intermédiaire, choisie parmi oxyde de chrome (Cr₂O₃), oxynitrure de chrome, oxyde d'aluminium-chrome (AlCr)₂O₃, oxynitrure d'aluminium-chrome ou un oxyde mélangé ou oxynitrure mélangé d'aluminium, chrome et d'autres métaux (AlCrMe₁, ..., Meₙ)₂-oxyde ou (AlCrMe₁, ..., Me)₂-oxynitrure, Me₁ ... Meₙ représentant un ou plusieurs autres métaux choisis parmi Hf, Y, Zr et Ru.

2. Outil de coupe selon la revendication 1, **caractérisé en ce que** la couche intermédiaire consiste en alumine de type y (γ-Al₂O₃).

3. Outil de coupe selon l'une des revendications 1 ou 2, **caractérisé en ce que** la couche fonctionnelle contenant du chrome consiste entièrement ou pour le moins de 90 % en volume d'oxyde d'aluminium-chrome (AlCr)₂O₃ rhomboédrique.

4. Outil de coupe selon l'une des revendications 1 à 3, **caractérisé en ce que**, parmi les éléments métalliques de la couche fonctionnelle, la teneur en chrome est d'au moins 70 % en parts de Cr ou au moins 85 % en parts de Cr ou au moins 95 % en parts de Cr.

5. Outil de coupe selon l'une des revendications 1 à 4, **caractérisé en ce que** la couche intermédiaire a été déposée par un procédé de pulvérisation par magnétron, procédé réactif de pulvérisation par magnétron, procédé double de pulvérisation par magnétron, procédé de pulvérisation par magnétron à impulsions de forte puissance (HIPIMS) ou par application simultanée de pulvérisation cathodique (dépôt par pulvérisation) et évaporation par arc (Arc-PVD).

6. Outil de coupe selon l'une des revendications 1 à 5, **caractérisé en ce que** la couche fonctionnelle a été déposée par un procédé d'évaporation par arc (Arc-PVD), procédé de pulvérisation par magnétron, procédé réactif de pulvérisation par magnétron, procédé double de pulvérisation par magnétron, procédé de pulvérisation par magnétron à impulsions de forte puissance (HIPIMS) ou par application simultanée de pulvérisation cathodique (dépôt par pulvérisation) et évaporation par arc (Arc-PVD)..

7. Outil de coupe selon l'une des revendications précédentes, **caractérisé en ce que** la couche de base présente une épaisseur de couche de 50 nm à 8 µm, de préférence de 500 nm à 5 µm, de manière particulièrement préférée de 2 µm à 4 µm.

8. Outil de coupe selon l'une des revendications précédentes, **caractérisé en ce que** la couche intermédiaire présente une épaisseur de couche de 1 nm à 2 µm, de préférence de 5 nm à 750 nm, de manière particulièrement préférée de 10 nm à 50 nm.

9. Outil de coupe selon l'une des revendications précédentes, **caractérisé en ce que** la couche fonctionnelle présente une épaisseur de couche de 100 nm à 10 µm, de préférence de 500 nm à 5 µm, de manière particulièrement préférée de 750 nm à 2 µm.

10. Outil de coupe selon l'une des revendications précédentes, **caractérisé en ce que** la couche fonctionnelle présente à la surface des contraintes de compression de moins que 2 GPa, de préférence moins que 1 GPa.

11. Outil de coupe selon l'une des revendications précédentes, **caractérisé en ce que** la couche de base consiste en nitrure de titane-aluminium (TiAIN) ou en nitrure d'aluminium-silicium (TiAlSiN).

12. Outil de coupe selon l'une des revendications précédentes, **caractérisé en ce que** la couche intermédiaire comprend de l'argon à 0,1 à 5 % en parts, de préférence à 0,5 à 4 % en parts, de manière particulièrement préférée à 1,0 à 3 % en parts.
